# EUROPEAN PATENT APPLICATION

(11) **EP 3 305 446 A1**
(43) Date of publication of application: **11.04.2018**
(21) Application number: 16800036.2
(22) Date of filing: 25.05.2016
(51) Int. Cl.: B23B 27/14, B23C 5/16, C23C 16/36

(54) **SURFACE-COATED CUTTING TOOL WITH RIGID COATING LAYER EXHIBITING EXCELLENT CHIPPING RESISTANCE**

(30) Priority: 26.05.2015 JP 2015106851; 20.05.2016 JP 2016101460
(71) Applicant: Mitsubishi Materials Corporation, Chiyoda-ku Tokyo 100-8117 (JP)
(72) Inventor: YANAGISAWA, Kousuke, Naka-shi Ibaraki 311-0102 (JP); TATSUOKA, Sho, Naka-shi Ibaraki 311-0102 (JP); SATO, Kenichi, Naka-shi Ibaraki 311-0102 (JP); YAMAGUCHI, Kenji, Naka-shi Ibaraki 311-0102 (JP)
(74) Representative: Gille Hrabal
(86) International application number: PCT/JP2016/065396
(87) International publication number: WO 2016/190332

(57) **Abstract**

Provided is a coated tool in which a hard coating layer has excellent chipping resistance and fracture resistance during high-speed intermittent cutting work and exhibits excellent wear resistance during long-term use. The hard coating layer includes at least a layer of a complex nitride or complex carbonitride expressed by a composition formula: (Ti₁₋ₓAlₓ) (C_{y}N_{1-y}), a periodic concentration variation is present in crystal grains of a complex nitride or complex carbonitride having a NaCl type face-centered cubic structure in the layer, a direction of the periodic concentration variation includes at least a direction at an angle of 30 degrees or less with respect to a plane parallel to a surface of a tool body, the layer preferably has a columnar structure, an area ratio of a periodic concentration variation of Ti and Al present is 40% by area or more, a period of the concentration variation is 1 to 10 nm, a difference between an average of local maximums and an average of local minimums of a periodically varying amount x of Al is 0.01 to 0.1, fine crystal grains having a hexagonal structure with an average grain size of 0.01 to 0.3 µm are present at grain boundaries between the crystal grains in a ratio of 5% by area or less.

## Description

### Technical Field

The present invention relates to a surface-coated cutting tool (hereinafter, referred to as coated tool), in which a hard coating layer has excellent chipping resistance and peeling resistance during intermittent cutting work of alloy steel, cast iron, stainless steel, or the like during which high-temperature heat is generated and an impact load is exerted on a cutting edge, and excellent cutting performance is thus exhibited during long-term use.

### Background Art

Hitherto, in general, coated tools in which the surfaces of tool bodies made of tungsten carbide (hereinafter, referred to as WC)-based cemented carbide, titanium carbonitride (hereinafter, referred to as TiCN)-based cermet, or a cubic boron nitride (hereinafter, referred to as cBN)-based ultrahigh-pressure sintered body (hereinafter, collectively referred to as a tool body) are coated with a Ti-Al-based complex nitride layer as a hard coating layer through a physical vapor deposition method are known, and it is known that these coated tools exhibit excellent wear resistance.

However, although the coated tool coated with the Ti-Al-based complex nitride layer in the related art has relatively excellent wear resistance, in a case of using the coated tool under high-speed intermittent cutting conditions, abnormal wear such as chipping easily occurs. Therefore, various suggestions for an improvement in the hard coating layer have been made.

For example, PTL 1 discloses that a hard coating layer which is formed of a layer of a complex nitride of Al and Ti, in which the layer of a complex nitride of Al and Ti satisfies the composition formula: (AlₓTi₁₋ₓ)N (here, x is 0.40 to 0.65 in atomic ratio), in a case where crystal orientation analysis is performed on the layer of a complex nitride through EBSD, the area ratio of crystal grains having a crystal orientation <100> in a range of 0 to 15 degrees from the normal direction of a surface-polished surface is 50% or more, and in a case where the angle between the adjacent crystal grains is measured, a crystal alignment in which the ratio of low angle grain boundaries (0 < θ ≤ 15°) is 50% or more is shown, is deposited on the surface of a tool body, and thus the hard coating layer exhibits excellent fracture resistance under high-speed intermittent cutting conditions.

However, in this coated tool, since the hard coating layer is deposited through a physical vapor deposition method, it is difficult to increase the amount x of Al to 0.65 or more, and it is desirable to further improve cutting performance.

From the above-described viewpoints, a technique in which the amount x of Al is increased to about 0.9 by forming a hard coating layer through a chemical vapor deposition method is suggested.

For example, PTL 2 suggests that the heat resistance and fatigue strength of a coated tool are improved by coating the outside of a TiCN layer and an Al₂O₃ layer as inner layers with a (Ti₁₋ₓAlₓ) N layer (here, x is 0.65 to 0.9 in atomic ratio) having a cubic structure or a cubic structure including a hexagonal structure as an outer layer using a chemical vapor deposition method, and applying a compressive stress of 100 to 1100 MPa to the outer layer.

In addition, for example, PTL 3 describes that by performing chemical vapor deposition in a mixed reaction gas of TiCl₄, AlCl₃, and NH₃ in a temperature range of 650°C to 900°C, a (Ti₁₋ₓAlₓ)N layer in which the value of the amount x of Al is 0.65 to 0.95 can be deposited. However, this literature is aimed at further coating an Al₂O₃ layer on the (Ti₁₋ₓAlₓ) N layer and thus improving a heat insulation effect. Therefore, the effect of the formation of the (Ti₁₋ₓAlₓ) N layer in which the value of the amount x of Al is increased to 0.65 to 0.95 on the cutting performance is not clear.

Furthermore, PTL 4 suggests a coated tool which is coated with a hard coating layer including at least a layer of a complex nitride or complex carbonitride (here, 0.60 ≤ x ≤ 0.95, 0 ≤ y ≤ 0.005 in atomic ratio) expressed by the composition formula: (Ti₁₋ₓAlₓ) (C_{y}N_{1-y}), in which crystal grains constituting the layer of a complex nitride or complex carbonitride has a cubic structure and a hexagonal structure, the area ratio of a cubic crystal phase is 30 to 80% by area, the crystal grains having the cubic structure have an average grain width W of 0.05 to 1.0 µm and an average aspect ratio of 5 or lower, and a concentration variation of Ti and Al is formed at a predetermined period in the crystal grains having the cubic structure, such that the coated tool has excellent hardness and toughness and exhibits excellent chipping resistance and fracture resistance.

### Citation List

### Patent Literature

[PTL 1] JP-A-2009-56540
[PTL 2] JP-T-2011-513594
[PTL 3] JP-T-2011-516722
[PTL 4] JP-A-2014-210333

### Summary of Invention

### Technical Problem

There has been a strong demand for power saving and energy saving during cutting work in recent years. In accordance with this, there is a trend toward a further increase in speed and efficiency during cutting work. Therefore, abnormal damage resistance such as chipping resistance, fracture resistance, and peeling resistance is further required for a coated tool, and excellent wear resistance is required during long-term use.

However, in the coated tool described in PTL 1, since the hard coating layer formed of the (Ti₁₋ₓAlₓ)N layer is deposited through the physical vapor deposition method and it is difficult to increase the amount x of Al in the hard coating layer, in a case where the coated tool is provided for high-speed intermittent cutting of alloy steel, cast iron, stainless steel, or the like, there is a problem in that it cannot be said that wear resistance and chipping resistance are sufficient.

On the other hand, in the coated tool described in PTL 2, although the coated tool has a predetermined hardness and excellent wear resistance, the toughness thereof is deteriorated. Therefore, in a case where the coated tool is provided for high-speed intermittent cutting work or the like of alloy steel, cast iron, or stainless steel, there are problems in that abnormal damage such as chipping, fracture, and peeling easily occurs and it cannot be said that satisfactory cutting performance is exhibited.

Furthermore, in the (Ti₁₋ₓAlₓ) N layer deposited through the chemical vapor deposition method described in PTL 3, the amount x of Al can be increased. In addition, since a cubic structure can be formed, a hard coating layer having a predetermined hardness and excellent wear resistance is obtained. However, there are problems in that the adhesion strength thereof to a tool body is insufficient and the toughness thereof is deteriorated.

Furthermore, in the coated tool in which the layer of a complex nitride or complex carbonitride expressed by (Ti₁₋ₓAlₓ) (C_{y}N_{1-y}) is deposited described in PTL 4, since the periodic concentration variation of Ti and Al is present in the crystal grains having the cubic structure in a layer thickness direction, strain is introduced into the cubic crystal grains, resulting in an increase in hardness. In addition, development of cracks particularly in the layer thickness direction is suppressed, and as a result, chipping resistance and fracture resistance are improved. However, there is a problem in that development of cracks in a direction parallel to a body caused by the shear force exerted on a surface where wear progresses during cutting is insufficiently suppressed.

Here, an object of the present invention is to provide a coated tool which has excellent toughness and exhibits excellent chipping resistance and wear resistance during long-term use even in a case of being provided for high-speed intermittent cutting of alloy steel, cast iron, stainless steel, or the like.

### Solution to Problem

Therefore, from the above-described viewpoints, the inventors intensively studied to improve the chipping resistance and wear resistance of a coated tool in which a hard coating layer containing at least a complex nitride or complex carbonitride of Ti and Al (hereinafter, sometimes referred to as "(Ti,Al) (C,N) " or " (Ti₁₋ₓAlₓ) (C_{y}N_{1-y})") is deposited through chemical vapor deposition. As a result, the following knowledge was obtained.

That is, the inventors intensively conducted researches while focusing on a concentration variation in the crystal grains of the (Ti₁₋ₓAlₓ) (C_{y}N_{1-y}) layer included in the hard coating layer. In a case where a periodic concentration variation of Ti and Al is formed in the crystal grains having a cubic crystal structure in the (Ti₁₋ₓAlₓ) (C_{y}N_{1-y}) layer, even when a high load is exerted on an cutting portion, a cushioning action against the shear force occurs, whereby development of cracks is suppressed, and the toughness of the (Ti,Al) (C,N) layer is improved. Furthermore, since the thermal conductivity in the layer thickness direction of the (Ti,Al)(C,N) layer is improved, a reduction in the hardness of the cutting portion that reaches a high temperature during cutting work is suppressed, and as a result, a reduction in the wear resistance is suppressed.

Therefore, novel knowledge that the chipping resistance of the (Ti,Al)(C,N) layer during high-speed intermittent cutting work can be improved was discovered.

Specifically, it was found that a hard coating layer includes at least a layer of a complex nitride or complex carbonitride of Ti and Al, in a case where the layer is expressed by the composition formula: (Ti₁₋ₓAlₓ) (C_{y}N_{1-y}) , an average amount X_{avg} of Al in a total amount of Ti and Al and an average amount Y_{avg} of C in a total amount of C and N (here, each of X_{avg} and Y_{avg} is in atomic ratio) respectively satisfy 0.40 ≤ X_{avg} ≤ 0.95 and 0 ≤ Y_{avg} ≤ 0.005, crystal grains having a NaCl type face-centered cubic structure are present in the crystal grains constituting the layer of a complex nitride or complex carbonitride, a periodic concentration variation of Ti and Al is present in the composition formula: (Ti₁₋ₓAlₓ) (C_{y}N_{1-y}) in the crystal grains having a NaCl type face-centered cubic structure, the direction of the periodic concentration variation is a direction at an angle of 30 degrees or less with respect to a plane parallel to the surface of a tool body, the period of the periodic concentration variation is preferably 1 to 10 nm, and the difference between the local maximum and the local minimum of a periodically varying amount x of Al is 0.01 to 0.1, whereby a cushioning action against the shear force exerted during cutting work occurs, development of cracks is correspondingly suppressed, chipping resistance and fracture resistance are improved, and excellent cutting performance is exhibited over a long period of time.

In addition, the (Ti₁₋ₓAlₓ) (C_{y}N_{1-y}) layer having the configuration described above can be formed by, for example, the following chemical vapor deposition method in which the composition of a reaction gas varies periodically on the surface of the tool body.

In a chemical vapor deposition reaction apparatus which is used, a gas group A of NH₃ and H₂ and a gas group B of TiCl₄, AlCl₃, N₂, C₂H₄, and H₂ are supplied into the reaction apparatus from separate gas supply tubes, the supplying of the gas group A and the gas group B into the reaction apparatus is performed so that, for example, the gases are allowed to flow at time intervals of a predetermined period for a shorter time than the period, the supplying of the gases of the gas group A and the gas group B has a phase difference of a time shorter than the time for which the gases are supplied, and the composition of the reaction gas on the surface of the tool body can be changed temporally between (a) the gas group A, (b) a mixed gas of the gas group A and the gas group B, and (c) the gas group B. Moreover, in the present invention, there is no need to introduce a long-term exhaust process intended for strict gas substitution. Therefore, as a gas supply method, for example, it is possible to realize the composition of the reaction gas on the surface of the tool body being able to be changed temporally between (a) a mixed gas primarily containing the gas group A, (b) a mixed gas of the gas group A and the gas group B, and (c) a mixed gas primarily containing the gas group B by rotating gas supply ports, rotating the tool body, or reciprocating the tool body.

The predetermined (Ti₁₋ₓAlₓ) (C_{y}N_{1-y}) layer can be formed on the surface of the tool body by performing a thermal CVD method for a predetermined time, for example, using, as the composition of the reaction gas (% by volume with respect to the total amount of the gas group A and the gas group B), the gas group A of NH₃: 1.0% to 2.5% and H₂: 60% to 75% and the gas group B of AlCl₃: 0.10% to 0.90%, TiCl₄: 0.10% to 0.30%, N₂: 0.0% to 12.0%, C₂H₄: 0% to 0.5%, and H₂: the remainder, under a reaction atmosphere pressure of 4.5 kPa to 5.0 kPa, at a reaction atmosphere temperature of 700°C to 800°C, and with a supply period of 1 to 2 seconds, a gas supply time of 0.05 to 0.12 seconds per one period, and a phase difference between the supply of the gas group A and the supply of the gas group B of 0.04 to 0.09 seconds.

As described above, since the gas group A and the gas group B are supplied so that the times at which the gas group A and the gas group B arrive at the surface of the tool body are different from each other, a difference in concentration between Ti and Al is locally formed in the crystal grains. As a result, particularly chipping resistance and fracture resistance are improved. Therefore, it was found that even in a case of being used for high-speed intermittent cutting work of alloy steel, cast iron, stainless steel, or the like during which intermittent and impact loads are exerted on a cutting edge, the hard coating layer can exhibit excellent wear resistance during long-term use.

The present invention is made based on the above-described knowledge and is characterized by including
"(1) A surface-coated cutting tool in which a hard coating layer is provided on a surface of a tool body made of any of tungsten carbide-based cemented carbide, titanium carbonitride-based cermet, or a cubic boron nitride-based ultrahigh-pressure sintered body, in which
   (a) the hard coating layer includes at least a layer of a complex nitride or complex carbonitride of Ti and Al with an average layer thickness of 1 to 20 µm,
   (b) the layer of a complex nitride or complex carbonitride includes at least crystal grains of a complex nitride or complex carbonitride having a NaCl type face-centered cubic structure, and
   (c) at least the crystal grains having a NaCl type face-centered cubic structure in which, in a case where the layer of a complex nitride or complex carbonitride is analyzed in an arbitrary section perpendicular to the surface of the tool body, a periodic concentration variation of Ti and Al is present in the crystal grains having a NaCl type face-centered cubic structure, and when a direction in which a period of a concentration variation in the periodic concentration variation of Ti and Al is minimized is obtained, an angle between the direction in which the period of the concentration variation is minimized and the surface of the tool body is 30 degrees or less, are present.
(2) The surface-coated cutting tool described in (1), in which, in a case where a composition of the layer of a complex nitride or complex carbonitride is expressed by a composition formula: (Ti₁₋ₓAlₓ) (C_{y}N_{1-y}) , an average amount X_{avg} of Al in a total amount of Ti and Al and an average amount Y_{avg} of C in a total amount of C and N (here, each of X_{avg} and Y_{avg} is in atomic ratio) respectively satisfy 0.40 ≤ X_{avg} ≤ 0.95 and 0 ≤ Y_{avg} ≤ 0.005.
(3) The surface-coated cutting tool described in (1) or (2), in which a ratio of the crystal grains having a NaCl type face-centered cubic structure in which, when the layer of a complex nitride or complex carbonitride is observed in the section, the periodic concentration variation of Ti and Al is present, and the angle between the direction in which the period of the concentration variation in the periodic concentration variation of Ti and Al is minimized and the surface of the tool body is 30 degrees or less, to an area of the layer of a complex nitride or complex carbonitride is 40% by area or more.
(4) The surface-coated cutting tool described in any one of (1) to (3), in which, in the crystal grains having a NaCl type face-centered cubic structure in which the periodic concentration variation of Ti and Al is present in the layer of a complex nitride or complex carbonitride and the angle between the direction in which the period of the concentration variation in the periodic concentration variation of Ti and Al is minimized and the surface of the tool body is 30 degrees or less, the period of the periodic concentration variation of Ti and Al is 1 to 10 nm, and a difference between an average of local maximums and an average of local minimums of a periodically varying amount x of Al is 0.01 to 0.1.
(5) The surface-coated cutting tool described in any one of (1) to (4), in which, regarding the layer of a complex nitride or complex carbonitride, in a case where the layer is observed in a sectional direction, at grain boundaries between the individual crystal grains having a NaCl type face-centered cubic structure in the layer of a complex nitride or complex carbonitride, fine crystal grains having a hexagonal structure are present, an area ratio of the fine crystal grains present is 5% by area or less, and an average grain size R of the fine crystal grains is 0.01 to 0.3 µm.
(6) The surface-coated cutting tool described in any one of (1) to (5), in which, between the tool body and the layer of a complex nitride or complex carbonitride of Ti and Al, a lower layer which is formed of a Ti compound layer including one layer or two or more layers of a Ti carbide layer, a Ti nitride layer, a Ti carbonitride layer, a Ti oxycarbide layer, and a Ti oxycarbonitride layer and has an average total layer thickness of 0.1 to 20 µm is present.
(7) The surface-coated cutting tool described in any one of (1) to (6), in which an upper layer which includes at least an aluminum oxide layer and has an average total layer thickness of 1 to 25 µm is formed in an upper portion of the layer of a complex nitride or complex carbonitride."

The present invention will be described below in detail.

Average Layer Thickness of Layer of Complex Nitride or Complex Carbonitride of Ti and Al:

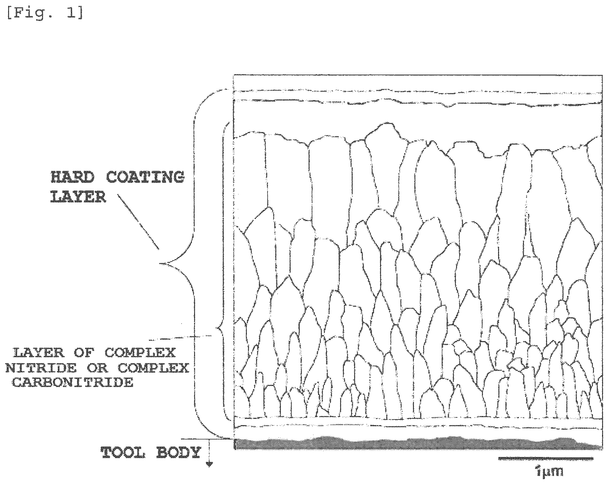

Fig. 1 is a schematic sectional view of the layer of a complex nitride or complex carbonitride of Ti and Al included in the hard coating layer of the present invention.

The hard coating layer of the present invention includes at least the layer of a complex nitride or complex carbonitride of Ti and Al expressed by the composition formula: (Ti₁₋ₓAlₓ) (C_{y}N_{1-y}) . The layer of a complex nitride or complex carbonitride has high hardness and excellent wear resistance, and the effect thereof is significantly exhibited particularly when the average layer thickness thereof is 1 to 20 µm. The reason for this is that when the average layer thickness thereof is smaller than 1 µm, the layer thickness thereof is too small to sufficiently ensure wear resistance during long-term use, and when the average layer thickness thereof is greater than 20 µm, the crystal grains of the layer of a complex nitride or complex carbonitride of Ti and Al are likely to coarsen and chipping easily occurs. Therefore, the average layer thickness thereof is determined to be 1 to 20 µm.

Composition of Layer of Complex Nitride or Complex Carbonitride of Ti and Al:
It is desirable that the layer of a complex nitride or complex carbonitride included in the hard coating layer of the present invention is controlled such that an average amount X_{avg} of Al in a total amount of Ti and Al and an average amount Y_{avg} of C in a total amount of C and N (here, each of X_{avg} and Y_{avg} is in atomic ratio) respectively satisfy 0.40 ≤ X_{avg} ≤ 0.95 and 0 ≤ Y_{avg} ≤ 0.005.

The reason for this is that when the average amount X_{avg} of Al is less than 0.40, the oxidation resistance of the layer of a complex nitride or complex carbonitride of Ti and Al deteriorates. Therefore, in a case where the layer is provided for high-speed intermittent cutting of alloy steel, cast iron, stainless steel, or the like, the wear resistance thereof is insufficient. On the other hand, when the average amount X_{avg} of Al is more than 0.95, the precipitation amount of hexagonal crystals with lower hardness increases, resulting in a reduction in hardness. Accordingly, the wear resistance thereof decreases. Therefore, it is desirable that the average amount X_{avg} of Al satisfies 0.40 ≤ X_{avg} ≤ 0.95.

In addition, when the average amount Y_{avg} of the component C contained in the layer of a complex nitride or complex carbonitride is a small amount in a range of 0 ≤ Y_{avg} ≤ 0.005, the adhesion between the layer of a complex nitride or complex carbonitride and the tool body or the lower layer is improved. In addition, the lubricity thereof is improved and thus an impact during cutting is relieved, resulting in an improvement in the fracture resistance and chipping resistance of the layer of a complex nitride or complex carbonitride. On the other hand, when the average amount Y_{avg} of the component C is outside of the range of 0 ≤ Y_{avg} ≤ 0.005, the toughness of the layer of a complex nitride or complex carbonitride decreases. Therefore, the fracture resistance and chipping resistance decrease, which is not preferable. Therefore, it is desirable that the average amount Y_{avg} of C satisfies 0 ≤ Y_{avg} ≤ 0.005.

Here, the amount Y_{avg} of C excludes the amount of C that is unavoidably contained even though gas containing C is not used as a gas raw material. Specifically, for example, the amount (atomic ratio) of the component C contained in the layer of a complex nitride or complex carbonitride in a case where the amount of C₂H₄ supplied as the gas raw material containing C is set to 0 is obtained as the unavoidable amount of C, and for example, a value obtained by subtracting the amount of C that is unavoidably contained from the amount (atomic ratio) of the component C contained in the layer of a complex nitride or complex carbonitride obtained in a case where C₂H₄ is intentionally supplied is determined to be Y_{avg}.

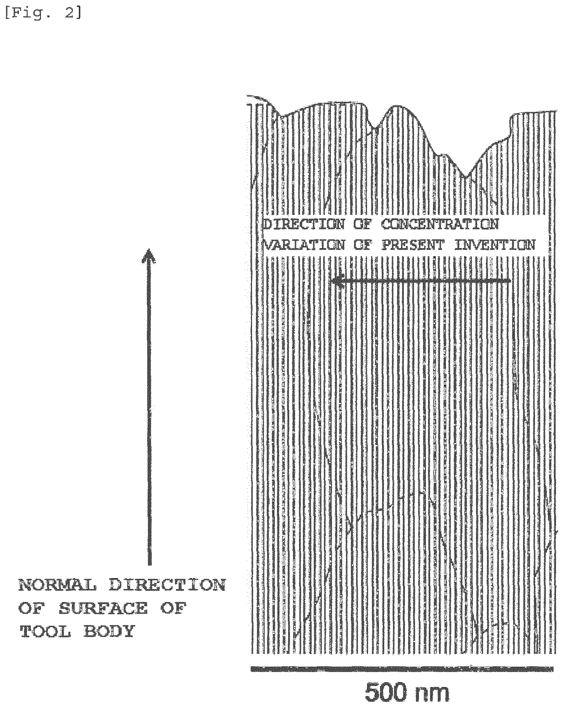

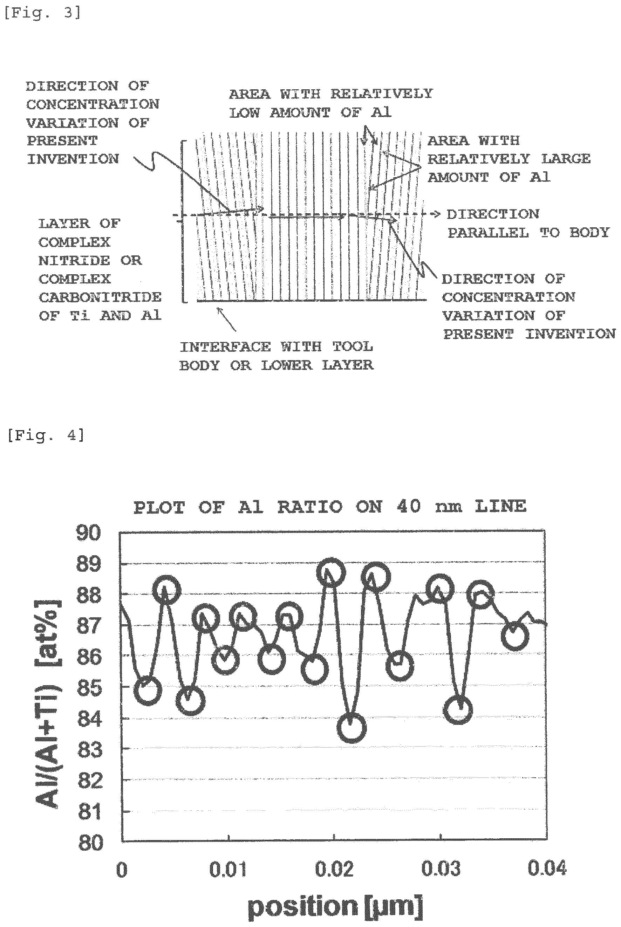

Periodic Concentration Variation:
As illustrated in schematic views in Figs. 2 and 3, the periodic concentration variation of Ti and Al is present in the crystal grains having a NaCl type face-centered cubic structure in the layer of a complex nitride or complex carbonitride, and at least the crystal grains having a NaCl type face-centered cubic structure in which the angle between the direction of the periodic concentration variation and a plane parallel to the surface of the tool body is 30 degrees or less need to be present.

"The angle between the direction of the periodic concentration variation and a plane parallel to the surface of the tool body is 30 degrees or less" is "in a case where the layer of a complex nitride or complex carbonitride included in the hard coating layer is analyzed in an arbitrary section perpendicular to the surface of the tool body, when a direction in which the period of the concentration variation is minimized in the periodic concentration variation of Ti and Al that is present in the crystal grains having a NaCl type face-centered cubic structure is obtained, the direction of the periodic concentration variation in which the angle between the direction in which the period of the concentration variation is minimized and the plane parallel to the surface of the tool body is 30 degrees or less" (hereinafter, abbreviated to "the direction of the concentration variation of the present invention").

Here, the reason that at least the crystal grains having a NaCl type face-centered cubic structure in which the angle between the direction of the periodic concentration variation and the plane parallel to the surface of the tool body is 30 degrees or less need to be present is as follows.

During the film formation of the present invention, since the reaction gas group A and the gas group B are supplied so that the times at which the gas group A and the gas group B arrive at the surface of the tool body are different from each other, a difference in concentration between Ti and Al is locally formed in the crystal grains. Therefore, in particular, in a case where the time interval between the periods at which the raw material gases are supplied to the surface of the tool body is short and the amount of a film formed per one period is small, due to the surface diffusion and rearrangement of Al and Ti atoms, the crystal grains are stabilized in the direction in which the angle between the direction of the periodic concentration variation and the plane parallel to the surface of the tool body is 30 degrees or less.

The periodic concentration variation in the direction at an angle of 30 degrees or less with respect to the plane parallel to the surface of the tool body suppresses the development of cracks in a direction parallel to the body caused by the shear force exerted on the surface where wear progresses during cutting, resulting in an improvement in toughness. However, when the angle between the direction of the periodic concentration variation and the plane parallel to the surface of the tool body exceeds 30 degrees, the effect of suppressing the development of cracks in the direction parallel to the body cannot be expected, and the effect of improving the toughness cannot also be expected. It is assumed that the effect of suppressing the development of cracks is exhibited due to bending or refraction in the direction of development at the boundary with different Ti and Al concentrations.

Therefore, in the present invention, the crystal grains having a NaCl type face-centered cubic structure in which the angle between the direction of the periodic concentration variation in the crystal grains and the plane parallel to the surface of the tool body is 30 degrees or less need to be present.

It is desirable that when the layer of a complex nitride or complex carbonitride included in the hard film layer of the present invention is observed in an arbitrary section, the ratio of the crystal grains having a NaCl type face-centered cubic structure with the direction of the concentration variation of the present invention to the area of the layer of a complex nitride or complex carbonitride is 40% by area or more.

The reason for this is that when the ratio of the crystal grains having a NaCl type face-centered cubic structure with the direction of the concentration variation of the present invention to the area of the layer of a complex nitride or complex carbonitride is less than 40% by area, the development of cracks in the direction parallel to the body caused by the shear force exerted on the plane where wear progresses during cutting cannot be sufficiently suppressed, and the effect of improving the toughness is insufficient.

In addition, it is preferable that the layer of a complex nitride or complex carbonitride included in the hard film layer of the present invention has a columnar structure. This is because the columnar structure has excellent wear resistance, and although fine crystal grains having a hexagonal structure can be contained at the grain boundaries between the cubic crystals having the columnar structure in the hard film layer (Ti₁₋ₓAlₓ) (C_{y}N_{1-y}) layer of the present invention, the presence of the fine hexagonal crystals having excellent toughness at the grain boundaries between the cubic crystals having the columnar structure causes a reduction in friction at the grain boundaries and an improvement in the toughness.

The area ratio of the crystal grains with the direction of the concentration variation of the present invention can be calculated by obtaining a contrast variation of an image corresponding to the periodic concentration variation of Ti and Al in an image of 1 µm × 1 µm using a transmission electron microscope or obtaining the direction of the concentration variation of each crystal grain in an area having the periodic concentration variation of Ti and Al confirmed by energy-dispersive X-ray spectroscopy (EDS), extracting crystal grains in which the angle between the direction of the periodic concentration variation and the surface of the tool body is 30 degrees or less (that is, crystal grains having the direction of the concentration variation of the present invention) therefrom, calculating the area of each of the crystal grains, obtaining the area ratio occupying the observation area of 1 µm × 1 µm for at least ten visual fields, and obtaining the average value thereof as the area of the crystal grains having the direction of the concentration variation of the present invention.

Furthermore, it is desirable that in the crystal grains having the direction of the concentration variation of the present invention, the period of the concentration variation is 1 to 10 nm, and the difference between the average of local maximums and the average of local minimums of a periodically varying amount x of Al is 0.01 to 0.1.

This is because when the period of the concentration variation is smaller than 1 nm, the degree of strain in the crystal grains becomes too large and there are more lattice defects, resulting in a reduction in the hardness, and when the period of the concentration variation is greater than 10 nm, a cushioning action for suppressing the development of cracks in the direction parallel to the body caused by the shear force exerted on the plane where wear progresses during cutting and improving the toughness cannot be sufficiently expected. Therefore, it is desirable that the period of the concentration variation is 1 to 10 nm.

In addition, this is because although strain is introduced into the crystal grains and the hardness is improved due to the presence of the periodic concentration variation of Ti and Al in the crystal grains, when the difference Δx between the average of local maximums and the average of local minimums of the amount x of Al, which is an index of the degree of the periodic concentration variation of Ti and Al, is less than 0.01, the degree of strain in the crystal grains is low, and a sufficient improvement in the hardness cannot be expected, and when the difference Δx between the between the average of local maximums and the average of local minimums of x is greater than 0.1, the degree of strain in the crystal grains becomes too large, there are more lattice defects, and hardness decreases.

Therefore, regarding the periodic concentration variation of Ti and Al present in the crystal grains having a NaCl type face-centered cubic structure, it is desirable that the difference Δx between the average of local maximums and the average of local minimums of the periodically varying amount x of Al is 0.01 to 0.1.

Fig. 4 shows an example of a graph of the periodic concentration variation of Ti and Al obtained by performing line analysis on the periodic concentration variation of Ti and Al present in the crystal grains through energy-dispersive X-ray spectroscopy (EDS) using the transmission electron microscope.

The direction of the periodic concentration variation in Fig. 4 is an example of a direction at an angle of 0 degrees with respect to the plane parallel to the surface of the tool body (that is, the direction parallel to the surface of the tool body).

Fine Hexagonal Crystal Grains Present in Layer of Complex Nitride or Complex Carbonitride of Ti and Al:
In the layer of a complex nitride or complex carbonitride of Ti and Al of the present invention, fine crystal grains having a hexagonal structure can be contained at the grain boundaries between the crystal grains having a NaCl type face-centered cubic structure.

Since the fine hexagonal crystals are present at the grain boundaries between the crystal grains having a NaCl type face-centered cubic structure with excellent hardness, grain boundary sliding is suppressed, resulting in an improvement in the toughness of the layer of a complex nitride or complex carbonitride of Ti and Al. However, when the area ratio of the fine crystal grains having a hexagonal structure is more than 5% by area, the hardness is relatively reduced, which is not preferable. In addition, when the average grain size R of the fine crystal grains having a hexagonal structure is smaller than 0.01 µm, the effect of suppressing grain boundary sliding is insufficient. When the average grain size R thereof is greater than 0.3 µm, the degree of strain in the layer increases and thus hardness decreases.

Therefore, the area ratio of the fine hexagonal grains present in the layer of a complex nitride or complex carbonitride of Ti and Al is preferably 5% by area or less, and the average grain size R of the fine hexagonal grains is preferably 0.01 to 0.3 µm.

The fine crystal grains having a hexagonal structure present at the crystal grain boundaries between the crystal grains having a NaCl type face-centered cubic structure can be identified by analyzing an electron beam diffraction pattern using the transmission electron microscope, and the average grain size of the fine crystal grains having a hexagonal structure can be obtained by measuring the grain size of the grains present in a measurement range of 1 µm × 1 µm including grain boundaries and calculating the average value thereof.

Lower Layer and Upper Layer:
The layer of a complex nitride or complex carbonitride of the present invention exhibits sufficient effects in itself. However, in a case where the lower layer which is formed of a Ti compound layer that includes one layer or two or more layers of a Ti carbide layer, a Ti nitride layer, a Ti carbonitride layer, a Ti oxycarbide layer, and a Ti oxycarbonitride layer and has an average total layer thickness of 0.1 to 20 µm is provided, and/or in a case where the upper layer which includes at least an aluminum oxide layer and has an average total layer thickness of 1 to 25 µm, is provided, together with the effects of these layers, better characteristics can be created. In a case where the lower layer which is formed of a Ti compound layer that includes one layer or two or more layers of a Ti carbide layer, a Ti nitride layer, a Ti carbonitride layer, a Ti oxycarbide layer, and a Ti oxycarbonitride layer is provided, when the average total layer thickness of the lower layer is smaller than 0.1 µm, the effect of the lower layer is insufficiently exhibited. On the other hand, when the average total layer thickness thereof is greater than 20 µm, the crystal grains easily coarsen and chipping easily occurs. In addition, when the average total layer thickness of the upper layer including an aluminum oxide layer is smaller than 1 µm, the effect of the upper layer is insufficiently exhibited. On the other hand, when the average total layer thickness thereof is greater than 25 µm, the crystal grains easily coarsen and chipping easily occurs.

### Advantageous Effects of Invention

According to the present invention, in the surface-coated cutting tool provided with the hard coating layer on the surface of the tool body, the hard coating layer includes at least the layer of a complex nitride or complex carbonitride of Ti and Al formed using a chemical vapor deposition method, the crystal grains having a NaCl type face-centered cubic structure are present in the layer of a complex nitride or complex carbonitride, the periodic concentration variation of Ti and Al is present in the crystal grains having a NaCl type face-centered cubic structure, and at least the crystal grains in which the direction of the periodic concentration variation is a direction at an angle of 30 degrees or less with respect to the plane parallel to the surface of the tool body are present. Therefore, the development of cracks in the direction parallel to the tool body is suppressed by a cushioning action against the shear force exerted during cutting work, and thus the chipping resistance and fracture resistance are improved.

Furthermore, in a case where the layer of a complex nitride or complex carbonitride of the present invention is expressed by the composition formula: (Ti₁₋ₓAlₓ) (C_{y}N_{1-y}) , it is preferable that the average amount X_{avg} of Al in a total amount of Ti and Al and the average amount Y_{avg} of C in a total amount of C and N (here, each of X_{avg} and Y_{avg} is in atomic ratio) respectively satisfy 0.40 ≤ X_{avg} ≤ 0.95 and 0 ≤ Y_{avg} ≤ 0.005, it is preferable that the period of the concentration variation is 1 to 10 nm and the difference between the average of local maximums and the average of local minimums of a periodically varying amount x of Al is 0.01 to 0.1, and it is preferable that the fine crystal grains having a hexagonal structure with an average grain size R of 0.01 to 0.3 µm are present at the crystal grain boundaries between the crystal grains having a NaCl type face-centered cubic structure in the layer of a complex nitride or complex carbonitride in an area ratio of 5% by area or less.

In addition, even in a case where the coated tool of the present invention provided with the hard coating layer is used for high-speed intermittent cutting work of alloy steel, cast iron, stainless steel, or the like during which intermittent and impact loads are exerted on a cutting edge, excellent wear resistance is exhibited during long-term use without the occurrence of chipping and fracture.

### Brief Description of Drawings

Fig. 1 is a film configuration schematic view schematically illustrating the section of a layer of a complex nitride or complex carbonitride of Ti and Al included in a hard coating layer of the present invention.
Fig. 2 is a schematic view illustrating a periodic concentration variation of Ti and Al present in crystal grains having a NaCl type face-centered cubic structure in the layer of a complex nitride or complex carbonitride of Ti and Al included in the hard coating layer of the present invention.
Fig. 3 is a schematic view illustrating the periodic concentration variation of Ti and Al formed in a direction at an angle of 30 degrees or less with respect to a plane parallel to the surface of a tool body in crystal grains having a NaCl type face-centered cubic structure in the layer of a complex nitride or complex carbonitride of Ti and Al included in the hard coating layer of the present invention.
Fig. 4 is a graph showing an example of the periodic concentration variation of Ti and Al obtained by performing line analysis on the concentration variation of Ti and Al present in the crystal grains having a NaCl type face-centered cubic structure of the present invention through energy-dispersive X-ray spectroscopy (EDS) using a transmission electron microscope.

### Description of Embodiments

Next, examples of a coated tool of the present invention will be described in more detail.

### Example 1

As raw material powders, a WC powder, a TiC powder, a TaC powder, a NbC powder, a Cr₃C₂ powder, and a Co powder, all of which had an average grain size of 1 to 3 µm, were prepared, and the raw material powders were mixed in mixing compositions shown in Table 1. Wax was further added thereto, and the mixture was blended in acetone by a ball mill for 24 hours and was decompressed and dried. Thereafter, the resultant was press-formed into green compacts having predetermined shapes at a pressure of 98 MPa, and the green compacts were sintered in a vacuum at 5 Pa under the condition that the green compacts were held at a predetermined temperature in a range of 1370°C to 1470°C for one hour. After the sintering, tool bodies A to C made of WC-based cemented carbide with insert shapes according to ISO standard SEEN1203AFSN were produced.

In addition, as raw material powders, a TiCN (TiC/TiN = 50/50 in terms of mass ratio) powder, an Mo₂C powder, a ZrC powder, a NbC powder, a WC powder, a Co powder, and a Ni powder, all of which had an average grain size of 0.5 to 2 µm, were prepared, and the raw material powders were mixed in mixing compositions shown in Table 2, were subjected to wet mixing by a ball mill for 24 hours, and were dried. Thereafter, the resultant was press-formed into a green compact at a pressure of 98 MPa, and the green compact was sintered in a nitrogen atmosphere at 1.3 kPa under the condition that the green compact was held at a temperature of 1500°C for one hour. After the sintering, a tool body D made of TiCN-based cermet with insert shapes according to ISO standard SEEN1203AFSN was produced.

Next, present invention coated tools 1 to 10 shown in Table 7 were produced by forming, on the surfaces of the tool bodies A to D, an initial film formation layer under forming conditions A to J shown in Tables 4 and 5, that is, under first stage film formation conditions and then forming a film under second stage film formation conditions, using a chemical vapor deposition apparatus. That is, the present invention coated tools 1 to 10 were produced by forming a (Ti₁₋ₓAlₓ) (C_{y}N_{1-y}) layer shown in Table 7 through a thermal CVD method for a predetermined time according to the forming conditions A to J shown in Tables 4 and 5, in which a gas group A of NH₃ and H₂ and a gas group B of TiCl₄, AlCl₃, N₂, and H₂ were used, in each gas supply method, a reaction gas composition (% by volume with respect to the total amount of the gas group A and the gas group B) included a gas group A of NH₃: 1.0% to 2.5% and H₂: 60% to 75% and a gas group B of AlCl₃: 0.10% to 0.90%, TiCl₄: 0.10% to 0.30%, N₂: 0.0% to 12.0%, C₂H₄: 0% to 0.5%, H₂: the remainder, a reaction atmosphere pressure was 4.5 kPa to 5.0 kPa, a reaction atmosphere temperature was 700°C to 800°C, a supply period was 1 to 2 seconds, a gas supply time per one period was 0.05 to 0.12 seconds, and a phase difference between the supply of the gas group A and the supply of the gas group B was 0.04 to 0.09 seconds.

In addition, in the present invention, the lower the film formation temperature of the layer of a complex nitride or complex carbonitride, the lower the ratio of pores in the initial film formation layer. Therefore, the hardness is increased, or the adhesion strength between the layer of a complex nitride or complex carbonitride and the lower layer is increased, resulting in an improvement in peeling resistance. On the other hand, the higher the film formation temperature at which the layer of a complex nitride or complex carbonitride is formed, the higher the crystallinity. Therefore, an effect of improving the wear resistance is achieved. Accordingly, in the present invention, the film formation is performed in two separate stages, and the first stage film formation is performed at a lower temperature than in the second stage film formation, resulting in the improvement in the peeling resistance and wear resistance.

In addition, a lower layer and an upper layer shown in Table 6 were formed on each of the present invention coated tools 1 to 10 under forming conditions shown in Table 3.

In addition, for the purpose of comparison, comparative coated tools 1 to 10 were produced by depositing hard coating layers including at least a layer of a complex nitride or complex carbonitride of Ti and Al on the surfaces of the tool bodies A to D as in the present invention coated tools 1 to 10 to have target layer thicknesses (µm) shown in Fig. 8 under conditions of comparative film formation processes shown in Tables 4 and 5. At this time, the comparative coated tools 1 to 10 were produced by forming the hard coating layers so that the composition of the reaction gas on the surface of the tool body was not changed temporally during a process of forming a (Ti₁₋ₓAlₓ) (C_{y}N_{1-y}) layer.

In addition, like the present invention coated tools 1 to 10, a lower layer and an upper layer shown in Table 6 were formed on the comparative coated tools 1 to 10 under the forming conditions shown in Table 3.

The section of each of constituent layers of the present invention coated tools 1 to 10 and the comparative coated tools 1 to 10 in the direction perpendicular to the tool body was measured using a scanning electron microscope (at a magnification of 5, 000x). An average layer thickness was obtained by measuring and averaging the layer thicknesses of five points in an observation visual field. All of the results showed substantially the same average layer thicknesses as the target layer thicknesses shown in Tables 7 and 8.

In addition, regarding the average amount X_{avg} of Al of the layer of a complex nitride or complex carbonitride, a sample, of which the surface was polished, was irradiated with electron beams from the sample surface side, and the average Al amount X_{avg} of Al was obtained by averaging 10 points of the analytic result of obtained characteristic X-rays, using an electron probe microanalyzer (EPMA) . The average amount Y_{avg} of C was obtained by secondary ion mass spectroscopy (SIMS). Ion beams were emitted toward a range of 70 µm × 70 µm from the sample surface side, and the concentration of components emitted by a sputtering action was measured in a depth direction. The average amount Y_{avg} of C represents the average value of the layer of a complex nitride or complex carbonitride of Ti and Al in the depth direction. However, the amount of C excludes an unavoidable amount of C, which was included even though gas containing C was not intentionally used as a gas raw material. Specifically, the amount (atomic ratio) of the component C contained in the layer of a complex nitride or complex carbonitride in a case where the amount of supplied C₂H₄ was set to 0 was obtained as the unavoidable amount of C, and a value obtained by subtracting the unavoidable amount of C from the amount (atomic ratio) of the component C contained in the layer of a complex nitride or complex carbonitride obtained in a case where C₂H₄ was intentionally supplied was obtained as Y_{avg}.

In addition, a small area of the layer of a complex nitride or complex carbonitride was observed by using the transmission electron microscope under the condition of an acceleration voltage of 200 kV, and area analysis from the section side was performed using energy-dispersive X-ray spectroscopy (EDS), whereby the presence or absence of a periodic concentration variation of Ti and Al in the composition formula: (Ti₁₋ₓAlₓ) (C_{y}N_{1-y}) in the crystal grains having the cubic structure was checked, and the area ratio of the crystal grains having the direction of the concentration variation of the present invention was obtained.

The results are shown in Tables 7 and 8. Furthermore, the angle of the plane parallel to the surface of the tool body with respect to the direction of the periodic concentration variation was measured as follows.

The angle could be obtained by observing an arbitrary area of 1 µm × 1 µm from an arbitrary section perpendicular to the body in the crystal grains having a NaCl type face-centered cubic structure using the transmission electron microscope and measuring the angle between the direction in which the periodic concentration variation of Ti and Al is present and the period of the periodic concentration variation of Ti and Al in the section is minimized and the surface of the tool body. In addition, the minimum angle of the measured "angle between the direction in which the period of the periodic concentration variation is minimized and the surface of the tool body" was determined as the direction (degrees) of the periodic concentration variation, and it was determined whether or not the direction of the periodic concentration variation was 30 degrees or less. A case where the direction of the periodic concentration variation was 30 degrees or less is indicated as "present" and a case where the direction was more than 30 degrees is indicated as "absent" in Tables 7 and 8.

In addition, regarding the crystal grains having the cubic structure in which the periodic concentration variation was present, the period of the concentration variation of Ti and Al was obtained through the observation of the small area using the transmission electron microscope and the line analysis from the section side using energy-dispersive X-ray spectroscopy (EDS).

As a method of measuring the period, regarding the crystal grains, magnification was set based on the results of the area analysis such that the concentration variation of about ten periods from the contrasting density of the composition was within the measurement range, the measurement of the period according to the line analysis through EDS along the direction of the periodic concentration variation of the surface of the tool body was performed on a range of at least five periods, and the average value thereof was obtained as the period of the periodic concentration variation of Ti and Al.

Furthermore, the difference Δx between the average of local maximums and the average of local minimums of the amount x of Al in the periodic concentration variation was obtained.

A specific measurement method is as follows.

Regarding the crystal grains, magnification was set based on the results of the area analysis such that the concentration variation of about ten periods from the contrasting density of the composition was within the measurement range, the line analysis through EDS along the direction of the periodic concentration variation of the surface of the tool body was performed on the range of at least five periods, and the difference between the average values of local maximums and local minimums of the periodic concentration variation of Ti and Al was obtained as Δx.

Regarding the crystal grain from which the minimum measurement value of the measured "angle between the direction in which the period of the periodic concentration variation is minimized and the surface of the tool body" was obtained, the period and Δx thereof are shown in Tables 7 and 8.

In addition, regarding the layer of a complex nitride or complex carbonitride, a plurality of visual fields were observed using the transmission electron microscope, and the area ratio of the fine crystal grains having a hexagonal structure present at the grain boundaries between the crystal grains having a NaCl type face-centered cubic structure and the average grain size R of the fine crystal grains having a hexagonal structure were measured.

Identification of fine hexagonal crystals present at grain boundaries was performed by analyzing an electron beam diffraction pattern using the transmission electron microscope. The average grain size of the fine hexagonal crystals was obtained by measuring the grain size of the grains present in the measurement range of 1 µm × 1 µm including grain boundaries, and the area ratio thereof was obtained from a value obtained by calculating the total area of the fine hexagonal crystals. Furthermore, regarding the grain size, circumscribed circles were created for grains identified as hexagonal crystals, the radii of the circumscribed circles were measured, and the average value was determined as the grain size.

The obtained results are shown in Tables 7 and 8.

**[Table 1]**

| Type | | Mixing composition (mass%) | | | | | |
|---|---|---|---|---|---|---|---|
| | | Co | TiC | TaC | NbC | Cr₃C₂ | WC |
| Tool body | A | 8.0 | 1.5 | - | 3.0 | 0.4 | Remainder |
| | B | 8.5 | - | 1.8 | 0.2 | - | Remainder |
| | C | 7.0 | - | - | - | - | Remainder |

**[Table 2]**

| Type | | Mixing composition (mass%) | | | | | | |
|---|---|---|---|---|---|---|---|---|
| | | Co | Ni | ZrC | NbC | M₂C | WC | TiCN |
| Tool body | D | 8 | 5 | 1 | 6 | 6 | 10 | Remainder |

**[Table 3]**

| Constituent layers of hard coating layer | | | Forming conditions (pressure of reaction atmosphere is expressed as kPa and temperature is expressed as °C) | | |
|---|---|---|---|---|---|
| Type | | Formation symbol | Reaction gas composition (% by volume) | Reaction atmosphere | |
| | | | | Pressure | Temperature |
| TiAlCN layer | TiAlCN | TiAlCN | See Table 4 | | |
| Ti compound layer | TiC | TiC | TiCl₄: 4.2%, CH₄: 8.5%, H₂: remainder | 7 | 800 |
| | TiN | TiN | TiCl₄: 4.2%, N₂: 35%, H₂: remainder | 7 | 800 |
| | l-TiCN | l-TiCN | TiCl₄: 2.0%, CH₃CN: 1.5%, N₂: 8%, H₂: remainder | 7 | 800 |
| | TiCNO | TiCNO | TiCl₄: 2%, CH₃CN: 0.6%, CO: 1%, N₂: 10%, H₂: remainder | 7 | 800 |
| Al₂O₃ layer | Al₂O₃ | Al₂O₃ | AlCl₃: 2.2%, CO₂: 5.5%, HCl: 2.2%, H₂S: 0.2%, H₂: remainder | 7 | 800 |

**[Table 4]**

| Formation of TiAlCN layer | | Gas conditions (reaction gas composition indicates proportion in total amount of gas group A and gas group B) | |
|---|---|---|---|
| Process type | Formation symbol | Reaction gas group A composition (% by volumo) | Reaction gas group B composition (% by volume) |
| **Present invention film forming process** | A | NH₃: 2.5 %, H₂: 67% | TiCl₄: 0.10%, AlCl₃: 0.90%, N₂ : 0%, C₂H₄: 0%, H₂ as remainder |
| | B | NH₃: 2.1 %, H₂: 68% | TiCl₄: 0.10%, AlCl₃: 0.30%, N₂: 0%, C₂H₄: 0%, H₂ as remainder |
| | C | NH₃: 1.9 %, H₂: 68% | TiCl₄:0.15%, AlCl₃: 0.25%, N₂: 0%, C₂H₄: 0%, H₂ as remainder |
| | D | NH₃: 1.5 %, H₂: 69% | TiCl₄: 0.20%, AlCl₃: 0.15%, N₂: 0%, C₂H₄: 0%, H₂ as remainder |
| | E | NH₃: 2.2 %, H₂: 62% | TiCl₄: 0.10%, AlCl₃: 0.10%, N₂: 12%, C₂H₄: 0%, H₂ as remainder |
| | F | NH₃: 2.0 %, H₂: 73% | TiCl₄: 0.15%, AlCl₃: 0.10%, N₂: 7%, C₂H,: 0%, H₂ as remainder |
| | G | NH₃: 2.2 %, H₂: 60% | TiCl₄: 0.18%, AlCl₃: 0.10%, N₂: 5%, C₂H₄: 0%, H₂ as remainder |
| | H | NH₃: 2.1 %, H₂: 60% | TiCl₄: 0.30%, AlCl₃: 0.10%, N₂: 0%, C₂H₄: 0.5%, H₂ as remainder |
| | I | NH₃: 1.6 %, H₂: 70% | TiCl₄: 0.15%, AlCl₃: 0.80%, N₂: 0%, C₂H₄: 0.5%, H₂ as remainder |
| | J | NH₃: 1.0 %, H₂; 74% | TiCl₄: 0.15%, AlCl₃: 0.40%, N₂: 0%, C₂H₄: 0.2%, H₂ as remainder |
| **Comparative film forming process** | A' | NH₃: 4.0 %, H₂: 78% | TiCl₄: 0.30%, AlCl₃: 0.30%, N₂: 3%, C₂H₄: 0.5%, H₂ as remainder |
| | B' | NH₃: 3.0 %, H₂: 73% | TiCl₄: 0.30%, AlCl₃: 0.50%, N₂: 0%, C₂H₄: 0.0%, H₂ as remainder |
| | C' | NH₃: 2.7 %, H₂: 70% | TiCl₄: 0.50%, AlCl₃: 0.90%, N₂: 0%, C₂H₄: 0.0%, H₂ as remainder |
| | D' | NH₃: 2.7 %. H₂: 78% | TiCl₄: 0.50%, AlCl₃: 1.20%, N₂: 0%, C₂H₄: 0.5%, H₂ as remainder |
| | E' | NH₃: 2.5 %, H₂: 72% | TiCl₄: 0.30%, AlCl₃: 0.80%, N₂: 5%, C₂H₄: 0.0%, H₂ as remainder |
| | F' | NH₃: 0.8 %, H₂: 75% | TiCl₄; 0.30%, AlCl₃: 0.50%, N₂: 7%, C₂H₄: 0.0%, H₂ as remainder |
| | G' | NH₃: 0.8 %, H₂: 71% | TiCl₄: 0.50%, AlCl₃: 0.90%, N₂: 5%, C₂H₄: 0.0%, H₂ as remainder |
| | H' | NH₃: 0.7 %, H₂: 70% | TiCl₄: 0.30%, AlCl₃: 1.10%, N₂: 0%, C₂H₄: 0.5%, H₂ as remainder |
| | | NH₃: 0.7 %, H₂: 70% | TiCl₄: 0.50%, AlCl₃: 1.00%, N₂: 0%, C₂H₄: 0.5%, H₂ as remainder |
| | J' | NH₃: 0.6 %, H₂: 75% | TiCl₄: 0.25%, AlCl₃: 1.20%, N₂: 0%, C₂H₄: 0.0%, H₂ as remainder |

**[Table 5]**

| Formation of hard coating layer | | Forming conditions (pressure of reaction atmosphere is expressed as kPa and temperature is expressed as °C) | | | | | | | Forming conditions (pressure of reaction atmosphere is expressed as kPa and temperature is expressed as °C) | | | | | | |
|---|---|---|---|---|---|---|---|---|---|---|---|---|---|---|---|
| | | First stage film formation conditions (formation of initial film formation layer) | | | | | | | Second stage film formation conditions | | | | | | |
| Process type | Formation symbol | Gas group A | | Gas group B | | Phase difference in supply between gas group A and gas group B (sec) | Reaction atmosphere | | Gas group A | | Gas group B | | Phase difference in supply between gas group A and gas group B (sec) | Reaction atmosphere | |
| | | Supply period (sec) | Supply time per one period (sec) | Supply period (sec) | Sul pply time per one period (sec) | | Pressure | Temperature | Supply period (sec) | Supply time per one period (sec) | Supply period (sec) | Supply pply time per one period (sec) | | Pressure | Temperature |
| Present invention film forming process | A | 1 | 0.05 | 1 | 0.05 | 0.04 | 5.0 | 700 | 1 | 0.05 | 1 | 0.05 | 0.04 | 5.0 | 800 |
| | B | 1.2 | 0.05 | 1.2 | 0.05 | 0.04 | 5.0 | 750 | 1 | 0.05 | 1 | 0.05 | 0.04 | 5.0 | 800 |
| | C | 1.2 | 0.05 | 1.2 | 0.05 | 0.04 | 5.0 | 700 | 2 | 0.12 | 2 | 0.12 | 0.09 | 4.5 | 800 |
| | D | 2 | 0.12 | 2 | 0.12 | 0.09 | 4.5 | 700 | 2 | 0.12 | 2 | 0.12 | 0.09 | 4.5 | 800 |
| | E | 1.5 | 0.10 | 1.5 | 0.10 | 0.05 | 5.0 | 700 | 1.5 | 0.10 | 1.5 | 0.10 | 0.05 | 5.0 | 750 |
| | F | 1.5 | 0.10 | 1.5 | 0.10 | 0.05 | 4.5 | 700 | 1.5 | 0.10 | 1.5 | 0.10 | 0.05 | 5.0 | 700 |
| | G | 2 | 0.12 | 2 | 0.12 | 0.05 | 4.5 | 800 | 1 | 0.05 | 1 | 0.05 | 0.05 | 5.0 | 800 |
| | H | 2 | 0.12 | 2 | 0.12 | 0.09 | 4.7 | 700 | 1 | 0.12 | 1 | 0.12 | 0.09 | 4.7 | 700 |
| | I | 2 | 0.05 | 2 | 0.05 | 0.05 | 4.7 | 750 | 2 | 0.12 | 2 | 0.12 | 0.09 | 4.7 | 750 |
| | J | 2 | 0.05 | 2 | 0.05 | 0.05 | 4.7 | 800 | 2 | 0.12 | 2 | 0.10 | 0.09 | 4.7 | 800 |
| Comparative film forming process | A' | - | - | - | - | - | - | - | 3 | 0.12 | 3 | 0.12 | 0.15 | 6.0 | 650 |
| | B' | - | - | - | - | - | - | - | 3 | 0.2 | 3 | 0.2 | 0.15 | 5.0 | 700 |
| | C' | 2 | 0.2 | 2 | 0.2 | 0.25 | 4 | 680 | 1 | 0.2 | 1 | 0.2 | 0.25 | 4.0 | 680 |
| | D' | 3 | 0.2 | 3 | 0.2 | 0.2 | 2.5 | 700 | 3 | 0.2 | 3 | 0.2 | 0.2 | 4.7 | 700 |
| | E' | 2.5 | 0.2 | 2.5 | 0.2 | 0.2 | 4 | 750 | 4 | 0.2 | 4 | 0.2 | 0.2 | 6.0 | 750 |
| | F' | - | - | - | - | - | - | - | 3 | 0.15 | 3 | 0.15 | 0.2 | 5.0 | 750 |
| | G' | 3 | 0.2 | 3 | 0.2 | 0.25 | 4.7 | 680 | 3 | 0.2 | 3 | 0.2 | 0.25 | 4.7 | 800 |
| | H' | 4 | 0.15 | 4 | 0.15 | 0.2 | 5.0 | 800 | 3 | 0.2 | 3 | 0.2 | 0.25 | 5.0 | 700 |
| | I' | - | - | - | - | - | - | - | 1.5 | 0.2 | 1.5 | 0.2 | 0.15 | 5.0 | 700 |
| | J' | - | - | - | - | - | - | - | 2 | 0.2 | 2 | 0.2 | 0.25 | 6.0 | 650 |

**[Table 6]**

| Type | | Tool body symbol | Lower layer (numerical value at the bottom indicates the average target layer thickness of the layer (µm)) | | | Upper layer (numerical value at the bottom indicates the average target layer thickness of the layer (µm) ) | |
|---|---|---|---|---|---|---|---|
| | | | First layer | Second layer | Third layer | First layer | Second layer |
| Present invention coated tool • Comparative coated tool | 1 | A | - | - | - | - | - |
| | 2 | B | TiN (0.3) | - | - | - | - |
| | 3 | C | TiN (0.2) | - | - | Al₂O₃ (2) | - |
| | 4 | D | TiN (0.3) | l-TiCN (2) | - | - | - |
| | 5 | A | - | - | - | - | - |
| | 6 | B | - | - | - | - | - |
| | 7 | D | - | - | - | - | - |
| | 8 | C | TiC (1.5) | l-TiCN (2.5) | - | l-TiCN (0.5) | Al₂O₃ (1) |
| | 9 | A | TiN (0.2) | l-TiCN (3) | TiCNO (0.5) | TiCNO (0.5) | Al₂O₃ (2) |
| | 10 | B | - | - | - | - | - |

**[Table 7]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| Present invention coated tool | 1 | A | A | 0.95 | 0.0001 or less | Present | 1 | 0.03 | 54 | 7 | 0.24 | 0.5 | 4.0 |
| | 2 | B | B | 0.77 | 0.0001 or less | Present | 2 | 0.05 | 67 | 2 | 0.06 | 0.5 | 4.0 |
| | 3 | c | C | 0.64 | 0.0001 or less | Present | 8 | 0.07 | 39 | 2 | 0.11 | 0.5 | 3.5 |
| | 4 | D | D | 0.4 | 0.0001 or less | Present | 15 | 0.16 | 33 | - | - | 0.5 | 2.0 |
| | 5 | A | E | 0.50 | 0.0001 or less | Present | 12 | 0.1 | 38 | 2 | 0.03 | 1.0 | 3.5 |
| | 6 | B | F | 0.39 | 0.0001 or less | Present | 9 | 0.11 | 39 | 1 | 0.01 | 0.5 | 5.0 |
| | 7 | c | G | 0.35 | 0.0001 or less | Present | 3 | 0.01 | 44 | - | - | 0.5 | 1.5 |
| | 8 | D | H | 0.24 | 0.0050 | Present | 10 | 0.12 | 36 | - | - | 0.5 | 1.0 |
| | 9 | A | I | 0.85 | 0.0033 | Present | 12 | 0.14 | 40 | 5 | 0.32 | 0.5 | 3.5 |
| | 10 | B | J | 0.71 | 0.021 | Present | 11 | 0.11 | 57 | 6 | 0.3 | 1.0 | 4.0 |

| | | | | | | | | | | | | | |
|---|---|---|---|---|---|---|---|---|---|---|---|---|---|
| (Note 1) Any of Xavg, Yavg, and Δx in boxes indicates atomic ratio. (Note 2) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. | | | | | | | | | | | | | |

**[Table 8]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| | 1 | A | A' | 0.5 | 0.0036 | - | - | - | - | 3 | 0.05 | - | 3.5 |
| | 2 | B | B' | 0.63 | 0.0001 or less | Absent* | 12 | 0.08 | 0 | - | - | - | 5.0 |
| | 3 | C | C' | 0.7 | 0.0001 or less | - | - | - | - | 10 | 0.02 | 0.8 | 5.0 |
| | 4 | D | D' | 0.7 | 0.0033 | - | - | - | - | 10 | 0.09 | 0.7 | 3.5 |
| Comparative coated tool | 5 | A | E' | 0.65 | 0.0001 or less | Absent* | 25 | 0.11 | 0 | 1 | 0.05 | 0.7 | 4.0 |
| | 6 | B | F' | 0.55 | 0.0001 or less | Absent* | 50 | 0.05 | 0 | 7 | 0.11 | - | 4.0 |
| | 7 | C | G' | 0.55 | 0.0001 or less | - | - | - | - | 7 | 0.1 | 0.5 | 3.5 |
| | 8 | D | H' | 0.72 | 0.0025 | Absent* | 12 | 0.07 | 0 | 15 | 0.34 | 1.0 | 3.5 |
| | 9 | A | I' | 0.6 | 0.0035 | - | - | - | - | 11 | 0.15 | - | 5.0 |
| | 10 | B | J' | 0.77 | 0.0001 or less | - | - | - | - | 29 | 0.28 | - | 5.0 |

| | | | | | | | | | | | | | |
|---|---|---|---|---|---|---|---|---|---|---|---|---|---|
| (Note 1) Mark * in boxes indicates outside of the range of the present invention. (Note 2) "-" in boxes indicates that there is no periodic concentration variation or there are no hexagonal fine crystal grains. (Note 3) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. (Note 4) Any of Xavg, Yavg, and Δx in boxes indicates atomic ratio. | | | | | | | | | | | | | |

Next, in a state in which each of the various coated tools was clamped to a cutter tip end portion made of tool steel with a cutter diameter of 125 mm by a fixing tool, the present invention coated tools 1 to 10 and the comparative coated tools 1 to 10 were subjected to wet high-speed face milling, which is a type of high-speed intermittent cutting of alloy steel, and a center-cut cutting test, which will be described below, and the flank wear width of a cutting edge was measured.

The results are shown in Table 9.

Tool body: tungsten carbide-based cemented carbide, titanium carbonitride-based cermet
Cutting test: wet high-speed face milling, center-cut cutting work
Cutter diameter: 125 mm
Work material: a block material of JIS SCM440 with a width of 100 mm and a length of 400 mm
Rotational speed: 994 min-1
Cutting speed: 390 m/min
Depth of cut: 3.0 mm
Feed per tooth: 0.2 mm/tooth
Cutting time: 6 minutes.
(a typical cutting speed is 220 m/min)

**[Table 9]**

| Type | | Flank wear width (mm) | Type | | Cutting test results (min) |
|---|---|---|---|---|---|
| Present invention coated tool | 1 | 0.13 | Comparative coated tool | 1 | 3.1* |
| | 2 | 0.13 | | 2 | 5.1* |
| | 3 | 0.15 | | 3 | 4.7* |
| | 4 | 0.18 | | 4 | 3.5* |
| | 5 | 0.17 | | 5 | 4.2* |
| | 6 | 0.17 | | 6 | 3.1* |
| | 7 | 0.17 | | 7 | 2.5* |
| | 8 | 0.18 | | 8 | 3.4* |
| | 9 | 0.14 | | 9 | 2.9* |
| | 10 | 0.15 | | 10 | 3.0* |

| | | | | | |
|---|---|---|---|---|---|
| Mark * in boxes of comparative coated tools indicates a cutting time (min) until the end of a service life caused by the occurrence of chipping. | | | | | |

### Example 2

As raw material powders, a WC powder, a TiC powder, a ZrC powder, a TaC powder, a NbC powder, a Cr₃C₂ powder, a TiN powder, and a Co powder, all of which had an average grain size of 1 to 3 µm, were prepared, and the raw material powders were mixed in mixing compositions shown in Table 10. Wax was further added thereto, and the mixture was blended in acetone by a ball mill for 24 hours and was decompressed and dried. Thereafter, the resultant was press-formed into green compacts having predetermined shapes at a pressure of 98 MPa, and the green compacts were sintered in a vacuum at 5 Pa under the condition that the green compacts were held at a predetermined temperature in a range of 1370°C to 1470°C for one hour. After the sintering, each of tool bodies E to G made of WC-based cemented carbide with insert shapes according to ISO standard CNMG120412 was produced by performing honing with R: 0.07 mm on a cutting edge portion.

In addition, as raw material powders, a TiCN (TiC/TiN = 50/50 in terms of mass ratio) powder, a NbC powder, a WC powder, a Co powder, and a Ni powder, all of which had an average grain size of 0.5 to 2 µm, were prepared, and the raw material powders were mixed in mixing compositions shown in Table 11, were subjected to wet mixing by a ball mill for 24 hours, and were dried. Thereafter, the resultant was press-formed into a green compact at a pressure of 98 MPa, and the green compact was sintered in a nitrogen atmosphere at 1.3 kPa under the condition that the green compact was held at a temperature of 1500°C for one hour. After the sintering, a tool body H made of TiCN-based cermet with an insert shape according to ISO standard CNMG120412 was produced by performing honing with R: 0.09 mm on a cutting edge portion.

Subsequently, present invention coated tools 11 to 20 were produced by forming (Ti₁₋ₓAlₓ) (C_{y}N_{1-y}) layers shown in Table 13 on the surfaces of the tool bodies E to G and the tool body H through a thermal CVD method for a predetermined time using a typical chemical vapor deposition apparatus under the forming conditions A to J shown in Tables 4 and 5.

In addition, a lower layer and an upper layer shown in Table 12 were formed in the present invention coated tools 11 to 20 under the forming conditions shown in Table 3.

In addition, for the purpose of comparison, comparative coated tools 11 to 20 shown in Table 14 were produced by depositing a hard coating layer on the surfaces of the same tool bodies E to G and the tool body H to have target layer thicknesses under the conditions shown in Tables 4 and 5 using a typical chemical vapor deposition apparatus, like the present invention coated tools. In addition, like the present invention coated tools 11 to 20, a lower layer and an upper layer shown in Table 12 were formed in the comparative coated tools 11 to 20 under the forming conditions shown in Table 3.

The section of each of constituent layers of the present invention coated tools 11 to 20 and the comparative coated tools 11 to 20 was measured using the scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 13 and 14.

In addition, regarding the hard coating layers of the present invention coated tools 11 to 20 and the comparative coated tools 11 to 20, using the same method as that described in Example 1, the average amount X_{avg} of Al and the average amount Y_{avg} of C were measured.

The results are shown in Tables 13 and 14.

It was confirmed through line analysis by energy-dispersive X-ray spectroscopy (EDS) using the transmission electron microscope (at a magnification of 200,000x) that a periodic composition distribution of Ti and Al was present in the cubic crystal grains of a complex nitride or complex carbonitride of Ti and Al included in the hard coating layers of the present invention coated tools 11 to 20, and the difference Δx between the average of local maximums and the average of local minimums of x was obtained.

Furthermore, the period of the concentration variation of Ti and Al was obtained by observing a small area of the crystal grains having the cubic structure in which the periodic concentration variation was present using the same transmission electron microscope and performing area analysis from the section side using energy-dispersive X-ray spectroscopy (EDS).

In addition, regarding the layer of a complex nitride or complex carbonitride, the crystal structure, the average grain size R, and the area ratio of the hexagonal fine crystal grains present at the grain boundaries between the crystal grains having a NaCl type face-centered cubic structure were measured using the transmission electron microscope and an electron backscatter diffraction apparatus.

The results are shown in Tables 13 and 14.

**[Table 10]**

| Type | | Mixing composition (mass%) | | | | | | | |
|---|---|---|---|---|---|---|---|---|---|
| | | Co | TiC | ZrC | TaC | NbC | Cr₃C₂ | TiN | WC |
| Tool body | E | 6.5 | - | 1.5 | - | 2.9 | 0.1 | 1.5 | Remainder |
| | F | 7.6 | 2.6 | - | 4.0 | 0.5 | - | 1.1 | |
| | G | 6.0 | - | - | - | - | - | | Remainder |

**[Table 11]**

| Type | | Mixing composition (mass%) | | | | |
|---|---|---|---|---|---|---|
| | | Co | Ni | NbC | WC | TiCN |
| Tool body | H | 11 | 4 | 6 | 15 | Remainder |

**[Table 12]**

| Type | | Tool body symbol | Lower layer (numerical value at the bottom indicates the average target layer thickness of the layer (µm)) | | | Upper layer (numerical value at the bottom indicates the average target layer thickness of the layer (µm)) | |
|---|---|---|---|---|---|---|---|
| | | | First layer | Second layer | Third layer | First layer | Second layer |
| Present invention coated tool Comparative coated tool | 11 | E | TiN (0.3) | - | - | - | - |
| | 12 | F | TiN (0.3) | l-TiCN (4) | - | Al₂O₃ (5) | - |
| | 13 | G | - | - | - | - | - |
| | 14 | H | - | - | - | - | - |
| | 15 | E | TiN (0.3) | l-TiCN (7) | - | - | - |
| | 16 | F | TiN (0.2) | l-TiCN (5) | TiCNO (0.5) | - | - |
| | 17 | H | - | - | - | - | - |
| | 18 | G | TiC (0.5) | l-TiCN (5) | - | l-TiCN (0.8) | Al₂O₃ (3.2) |
| | 19 | E | TiN (0.2) | l-TiCN (5) | TiCNO (0.5) | TiCNO (0.5) | Al₂O₃ (5) |
| | 20 | F | TiN (0.3) | - | - | TiCNO (1) | Al₂O₃ (3.5) |

**[Table 13]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| Present invention coated tool | 11 | E | A | 0.94 | 0.0001 or less | Present | 2 | 0.04 | 50 | 9 | 0.18 | 1.0 | 10.0 |
| | 12 | F | B | 0.78 | 0.0001 or less | Present | 2 | 0.04 | 61 | 1 | 0.08 | 1.0 | 16.0 |
| | 13 | G | c | 0.63 | 0.0001 or less | Present | 9 | 0.06 | 44 | 2 | 0.1 | 0.5 | 7.0 |
| | 14 | H | D | 0.39 | 0.0001 or less | Present | 14 | 0.11 | 31 | 0 | - | 1.0 | 12.0 |
| | 15 | E | E | 0.50 | 0.0001 or less | Present | 13 | 0.08 | 37 | 1 | 0.02 | 1.0 | 8.0 |
| | 16 | F | F | 0.37 | 0.0001 or less | Present | 8 | 0.09 | 44 | 1 | 0.02 | 2.0 | 10.0 |
| | 17 | H | G | 0.35 | 0.0001 or less | Present | 4 | 0.01 | 55 | 0 | - | 0.5 | 11.0 |
| | 18 | G | H | 0.25 | 0.0050 | Present | 11 | 0.15 | 38 | 0 | - | 2.0 | 17.0 |
| | 19 | E | I | 0.85 | 0.0038 | Present | 13 | 0.15 | 48 | 6 | 0.31 | 0.5 | 15.0 |
| | 20 | F | J | 0.72 | 0.0025 | Present | 13 | 0.13 | 52 | 7 | 0.34 | 3.0 | 20.0 |

| | | | | | | | | | | | | | |
|---|---|---|---|---|---|---|---|---|---|---|---|---|---|
| (Note 1) Any of Xavg, Yavg, and Δx in boxes indicates atomic ratio. (Note 2) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. | | | | | | | | | | | | | |

**[Table 14]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| | 11 | E | A' | 0.5 | 0.0036 | - | - | - | - | 3 | 0.05 | - | 12.0 |
| | 12 | F | B' | 0.62 | 0.0001 or less | Absent* | 10 | 0.1 | 0 | - | - | - | 15.0 |
| | 13 | G | C' | 0.71 | 0.0001 or less | - | - | - | - | 12 | 0.02 | 0.8 | 7.0 |
| | 14 | H | D' | 0.7 | 0.0033 | - | - | - | - | 14 | 0.09 | 0.7 | 10.0 |
| Comparative coated tool | 15 | E | E' | 0.65 | 0.0001 or less | Absent* | 31 | 0.15 | 0 | 2 | 0.05 | 0.7 | 10.0 |
| | 16 | F | F' | 0.55 | 0.0001 or less | Absent* | 48 | 0.08 | 0 | 5 | 0.12 | - | 10.0 |
| | 17 | H | G' | 0.54 | 0.0001 or less | - | - | - | - | 8 | 0.11 | 0.5 | 13.0 |
| | 18 | G | H' | 0.72 | 0.0025 | Absent* | 11 | 0.03 | 0 | 16 | 0.35 | 1.0 | 17.0 |
| | 19 | E | I' | 0.6 | 0.0035 | - | - | - | - | 12 | 0.15 | - | 15.0 |
| | 20 | F | J' | 0.78 | 0.0001 or less | - | - | - | - | 29 | 0.31 | - | 19.0 |

| | | | | | | | | | | | | | |
|---|---|---|---|---|---|---|---|---|---|---|---|---|---|
| (Note 1) Mark * in boxes indicates outside of the range of the present invention. (Note 2) "-" in boxes indicates that there is no periodic concentration variation or there are no hexagonal fine crystal grains. (Note 3) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. (Note 4) Any of Xavg, Yavg, and Δx in boxes indicates atomic ratio. | | | | | | | | | | | | | |

Next, in a state in which each of the various coated tools was screwed to a tip end portion of an insert holder made of tool steel by a fixing tool, the present invention coated tools 11 to 20 and the comparative coated tools 11 to 20 were subjected to a wet high-speed intermittent cutting test for stainless steel, and a wet high-speed intermittent cutting test for cast iron, which will be described below, and the flank wear width of a cutting edge was measured in either case.

### Cutting conditions 1:

Work material: a round bar with four longitudinal grooves formed at equal intervals in the longitudinal direction of JIS SUS304
Cutting speed: 300 m/min
Depth of cut: 1.5 mm
Feed: 0.2 mm/rev
Cutting time: 2 minutes,
(a typical cutting speed is 150 m/min)

### Cutting conditions 2:

Work material: a round bar with four longitudinal grooves formed at equal intervals in the longitudinal direction of JIS FCD800
Cutting speed: 350 m/min
Depth of cut: 2.0 mm
Feed: 0.3 mm/rev
Cutting time: 3 minutes,
(a typical cutting speed is 200 m/min)

The results of the cutting test are shown in Table 15.

**[Table 15]**

| Type | | Flank wear width (mm) | | Type | | Cutting test results (min) | |
|---|---|---|---|---|---|---|---|
| | | Cutting conditions 1 | Cutting conditions 2 | | | Cutting conditions 1 | Cutting conditions 2 |
| Present invention coated tool | 11 | 0.13 | 0.13 | Comparative coated tool | 11 | 0.8 | 1.5 |
| | 12 | 0.12 | 0.12 | | 12 | 1.5 | 2.3 |
| | 13 | 0.13 | 0.15 | | 13 | 1.2 | 2.5 |
| | 14 | 0.14 | 0.17 | | 14 | 1.3 | 2.4 |
| | 15 | 0.14 | 0.18 | | 15 | 1.6 | 2.9 |
| | 16 | 0.16 | 0.17 | | 16 | 1.2 | 1.3 |
| | 17 | 0.17 | 0.19 | | 17 | 0.8 | 1.5 |
| | 18 | 0.16 | 0.18 | | 18 | 1.4 | 2.8 |
| | 19 | 0.14 | 0.14 | | 19 | 0.9 | 1.2 |
| | 20 | 0.13 | 0.15 | | 20 | 1.2 | 2.6 |

| | | | | | | | |
|---|---|---|---|---|---|---|---|
| Mark * in boxes of comparative coated tools indicates a cutting time (min) until the end of a service life caused by the occurrence of chipping. | | | | | | | |

### Example 3

As raw material powders, a cBN powder, a TiN powder, a TiC powder, an Al powder, and an Al₂O₃ powder, all of which had an average grain size in a range of 0.5 to 4 µm, were prepared, and the raw material powders were mixed in mixing compositions shown in Table 16. The mixture was subjected to wet mixing by a ball mill for 80 hours and was dried. Thereafter, the resultant was press-formed into green compacts having dimensions with a diameter of 50 mm and a thickness of 1.5 mm at a pressure of 120 MPa, and the green compacts were then sintered in a vacuum atmosphere at a pressure of 1 Pa under the condition that the green compacts were held at a predetermined temperature in a range of 900°C to 1300°C for 60 minutes, thereby producing cutting edge preliminary sintered bodies. In a state in which the preliminary sintered body was superimposed on a support piece made of WC-based cemented carbide, which was additionally prepared to contain Co: 8 mass% and WC: the remainder and have dimensions with a diameter of 50 mm and a thickness of 2 mm, the resultant was loaded in a typical ultrahigh-pressure sintering apparatus, and was subjected to ultrahigh-pressure sintering under typical conditions including a pressure of 4 GPa and a holding time of 0.8 hours at a predetermined temperature in a range of 1200°C to 1400°C. After the sintering, upper and lower surfaces were polished using a diamond grinding wheel, and were split into predetermined dimensions by a wire electric discharge machining apparatus. Furthermore, the resultant was brazed to a brazing portion (corner portion) of an insert body made of WC-based cemented carbide having a composition including Co: 5 mass%, TaC: 5 mass%, and WC: the remainder and a shape (a 80° rhombic shape with a thickness of 4.76 mm and an inscribed circle diameter of 12.7 mm) of JIS standard CNGA120408 using a brazing filler metal made of a Ti-Zr-Cu alloy having a composition including Zr: 37.5%, Cu: 25%, and Ti: the remainder in terms of mass%, and the outer circumference thereof was machined into predetermined dimensions. Thereafter, each of tool bodies a and b with an insert shape according to ISO standard CNGA120408 was produced by performing honing with a width of 0.13 mm and an angle of 25° on a cutting edge portion and performing finish polishing on the resultant.

**[Table 16]**

| Type | | Mixing composition (mass%) | | | | |
|---|---|---|---|---|---|---|
| | | TiN | TiC | Al | Al₂O₃ | cBN |
| Tool body | a | 50 | - | 5 | 3 | Remainder |
| | b | - | 50 | 4 | 3 | Remainder |

Subsequently, present invention coated tools 21 to 26 shown in Table 18 were produced by depositing hard coating layers including at least a (Ti₁₋ₓAlₓ) (C_{y}N_{1-y}) layer on the surfaces of the tool bodies a and b using a typical chemical vapor deposition apparatus to have target layer thicknesses under the conditions shown in Tables 4 and 5 in the same method as that in Example 1. In addition, a lower layer and an upper layer shown in Table 17 were formed in the present invention coated tools 21 to 30 under the forming conditions shown in Table 3.

In addition, for the purpose of comparison, comparative coated tools 21 to 26 shown in Table 19 were produced by depositing hard coating layers including at least a (Ti₁₋ₓAlₓ) (C_{y}N_{1-y}) layer on the surfaces of the same tool bodies a and b to have target layer thicknesses under the conditions shown in Tables 4 and 5 using a typical chemical vapor deposition apparatus. In addition, like the present invention coated tools 21 to 30, a lower layer and an upper layer shown in Table 17 were formed in the comparative coated tools 21 to 30 under the forming conditions shown in Table 3.

The section of each of constituent layers of the present invention coated tools 21 to 30 and the comparative coated tools 21 to 30 was measured using the scanning electron microscope (at a magnification of 5,000x). An average layer thickness was obtained by measuring and averaging the layer thicknesses of five points in an observation visual field. All of the results showed substantially the same average layer thicknesses as the target layer thicknesses shown in Tables 18 and 19.

In addition, regarding the hard coating layers of the present invention coated tools 21 to 30 and the comparative coated tools 21 to 30, using the same method as that described in Example 1, the average amount X_{avg} of Al and the average amount Y_{avg} of C were measured.

Furthermore, using the same method as that described in Example 1, the period of the periodic concentration variation of Ti and Al present in the cubic crystal grains, the difference Δx between the average of local maximums and the average of local minimums of x in the concentration variation, the crystal structure, the average grain size R, and the area ratio of the hexagonal fine crystal grains present at the grain boundaries between the individual crystal grains having a NaCl type face-centered cubic structure were measured.

The results are shown in Tables 18 and 19.

**[Table 17]**

| Type | | Tool body symbol | Lower layer (numerical value at the bottom indicates the average target layer thickness of the layer (µm)) | | Upper layer (numerical value at the bottom indicates the average target layer thickness of the layer (µm)) |
|---|---|---|---|---|---|
| | | | First layer | Second layer | |
| Present invention coated tool Comparative coated tool | 21 | a | - | - | - |
| | 22 | b | TiN (0.3) | l-TiCN (1.0) | Al₂O₃ (1.5) |
| | 23 | a | - | - | - |
| | 24 | b | - | - | - |
| | 25 | a | - | - | - |
| | 26 | a | - | - | - |
| | 27 | b | TiN (0.2) | l-TiCN (0.8) | - |
| | 28 | a | TiC (0.5) | l-TiCN (1.5) | (1.5) |
| | 29 | b | - | - | - |
| | 30 | a | TiN (0.3) | l-TiCN (1.0) | |

**[Table 18]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| Present invention coated tool | 21 | a | A | 0.95 | 0.0001 or less | Present | 2 | 0.05 | 54 | 7 | 0.22 | 0.5 | 2.0 |
| | 22 | b | B | 0.79 | 0.0001 or less | Present | 3 | 0.04 | 63 | 2 | 0.05 | 0.5 | 1.5 |
| | 23 | a | c | 0.65 | 0.0001 or less | Present | 8 | 0.05 | 48 | 2 | 0.09 | 0.5 | 2.5 |
| | 24 | b | D | 0.39 | 0.0001 or less | Present | 12 | 0.12 | 30 | 0 | - | 0.5 | 3.0 |
| | 25 | a | E | 0.50 | 0.0001 or less | Present | 11 | 0.09 | 35 | 2 | 0.04 | 0.6 | 3.0 |
| | 26 | b | F | 0.36 | 0.0001 or less | Present | 6 | 0.11 | 39 | 4 | 0.06 | 0.6 | 2.5 |
| | 27 | a | G | 0.36 | 0.0001 or less | Present | 4 | 0.02 | 48 | 0 | - | 0.4 | 1.5 |
| | 28 | b | H | 0.24 | 0.0051 | Present | 9 | 0.13 | 39 | 0 | - | 0.4 | 1.0 |
| | 29 | a | I | 0.84 | 0.0036 | Present | 14 | 0.14 | 50 | 9 | 0.29 | 0.4 | 1.0 |
| | 30 | b | J | 0.72 | 0.0023 | Present | 13 | 0.11 | 58 | 6 | 0.36 | 0.4 | 1.5 |

| | | | | | | | | | | | | | |
|---|---|---|---|---|---|---|---|---|---|---|---|---|---|
| (Note 1) Any of Xavg, Yavg, and Δx in boxes indicates atomic ratio. (Note 2) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. | | | | | | | | | | | | | |

**[Table 19]**

| Type | | Tool body symbol | Hard coating layer | | | | | | | | | | |
|---|---|---|---|---|---|---|---|---|---|---|---|---|---|
| | | | Layer of complex nitride or complex carbonitride of Ti and Al (Ti₁₋ₓAlₓ) (C_{y}N_{1-y}) | | | | | | | | | | |
| | | | Formation symbol of TiAlCN film forming process (see Tables 4 and 5) | Average amount X_{avg} of Al | Average amount Y_{avg} of C | Periodic concentration variation | | | | Hexagonal fine crystal grains | | Target film thickness of initial layer of first stage film formation (µm) | Target total film thickness (µm) |
| | | | | | | Presence or absence of concentration variation of present invention | Period (nm) | Δx | Area ratio (% by area) | Area ratio (% by area) | Average grain size R (µm) | | |
| | 21 | a | A' | 0.5 | 0.0039 | - | - | - | - | 1 | 0.06 | - | 1.5 |
| | 22 | b | B' | 0.63 | 0.0001 or less | Absent* | 12 | 0.1 | 0 | - | - | - | 2.0 |
| | 23 | a | C' | 0.71 | 0.0001 or less | - | - | - | - | 1 | 0 | 0.8 | 2.0 |
| | 24 | b | D' | 0.7 | 0.0034 | - | - | - | - | 10 | 0.06 | 0.7 | 3.0 |
| Present invention coated tool | 25 | a | E' | 0.66 | 0.0001 or less | Absent* | 30 | 0.12 | 0 | 1 | 0.06 | 0.7 | 1.5 |
| | 26 | b | F' | 0.55 | 0.0001 or less | Absent* | 54 | 0.04 | 0 | 5 | 0.12 | - | 1.5 |
| | 27 | a | G' | 0.55 | 0.0001 or less | - | - | - | - | 8 | 0.11 | 0.5 | 2.0 |
| | 28 | b | H' | 0.72 | 0.0027 | Absent* | 20 | 0.1 | 0 | 14 | 0.34 | 1.0 | 1.5 |
| | 29 | a | I' | 0.61 | 0.0035 | - | - | - | - | 13 | 0.16 | - | 1.0 |
| | 30 | b | J' | 0.77 | 0.0001 or less | - | - | - | - | 30 | 0.33 | - | 2.0 |

| | | | | | | | | | | | | | |
|---|---|---|---|---|---|---|---|---|---|---|---|---|---|
| (Note 1) Mark * in boxes indicates outside of the range of the present invention (Note 2) "-" in boxes indicates that there is no periodic concentration variation or there are no hexagonal fine crystal grains. (Note 3) "Presence or absence of concentration variation of present invention" in boxes indicates "Present" in a case where the minimum angle of "the angle between a direction in which the period of a periodic concentration variation is minimized and the surface of a tool body" is 30 degrees or less and indicates "Absent" in a case where the minimum angle is more than 30 degrees. (Note 4) Any of Xavg, Yavg, and Δx in boxes indicates atomic ratio. | | | | | | | | | | | | | |

Next, in a state in which each of the various coated tools was screwed to a tip end portion of an insert holder made of tool steel by a fixing tool, the present invention coated tools 21 to 30 and the comparative coated tools 21 to 30 were subjected to a dry high-speed intermittent cutting work test for cast iron, which will be described below, and the flank wear width of a cutting edge was measured.
Tool body: cubic boron nitride-based ultrahigh-pressure sintered body
Cutting test: dry high-speed intermittent cutting work for cast iron
Work material: a round bar with eight longitudinal grooves formed at equal intervals in the longitudinal direction of JIS FCD800
Cutting speed: 300 m/min
Depth of cut: 0.1 mm
Feed: 0.2 mm/rev
Cutting time: 3 minutes

The results of the cutting test are shown in Table 20.

**[Table 20]**

| Type | | Flank wear width (mm) | Type | | Cutting test results (min) |
|---|---|---|---|---|---|
| Present invention coated tool | 21 | 0.13 | Comparative coated tool | 21 | 1.8 |
| | 22 | 0.14 | | 22 | 2.2 |
| | 23 | 0.16 | | 23 | 2.7 |
| | 24 | 0.18 | | 24 | 2.4 |
| | 25 | 0.17 | | 25 | 2.6 |
| | 26 | 0.18 | | 26 | 1.6 |
| | 27 | 0.19 | | 27 | 1.4 |
| | 28 | 0.18 | | 28 | 2.5 |
| | 29 | 0.14 | | 29 | 2.0 |
| | 30 | 0.16 | | 30 | 2.2 |

| | | | | | |
|---|---|---|---|---|---|
| Mark * in boxes of comparative coated tools indicates a cutting time (min) until the end of a service life caused by the occurrence of chipping. | | | | | |

From the results shown in Tables 9, 15, and 20, regarding the coated tools of the present invention, since the periodic concentration variation of Ti and Al was present in the direction at an angle of 30 degrees or less with respect to the plane parallel to the surface of the tool body in the crystal grains having a NaCl type face-centered cubic structure constituting the layer of a complex nitride or complex carbonitride of Al and Ti included in the hard coating layer, a cushioning action against the shear force during cutting work occurs. Therefore, the propagation and development of cracks were suppressed, and the toughness was improved.

Therefore, even in a case of being used for high-speed intermittent cutting work during which intermittent and impact loads were exerted on a cutting edge, chipping resistance and fracture resistance were excellent, and as a result, excellent wear resistance was exhibited during long-term use.

Contrary to this, it was apparent that in the comparative coated tools in which the periodic concentration variation specified in the present invention was not present in the crystal grains having a NaCl type face-centered cubic structure constituting the layer of a complex nitride or complex carbonitride of Al and Ti included in the hard coating layer, in a case of being used for high-speed intermittent cutting work during which high-temperature heat is generated and intermittent and impact loads are exerted on a cutting edge, the end of the service life thereof was reached within a short time due to the occurrence of chipping, fracture, and the like.

### Industrial Applicability

As described above, the coated tool of the present invention can be used as a coated tool for various work materials as well as for high-speed intermittent cutting work of alloy steel, cast iron, stainless steel, and the like and further exhibits excellent chipping resistance during long-term use, thereby sufficiently satisfying an improvement in performance of a cutting device, power saving and energy saving during cutting work, and a further reduction in costs.

## Claims

1. A surface-coated cutting tool in which a hard coating layer is provided on a surface of a tool body made of any of tungsten carbide-based cemented carbide, titanium carbonitride-based cermet, or a cubic boron nitride-based ultrahigh-pressure sintered body, wherein
(a) the hard coating layer includes at least a layer of a complex nitride or complex carbonitride of Ti and Al with an average layer thickness of 1 to 20 µm,
(b) the layer of a complex nitride or complex carbonitride includes at least crystal grains of a complex nitride or complex carbonitride having a NaCl type face-centered cubic structure, and
(c) at least the crystal grains having a NaCl type face-centered cubic structure in which, in a case where the layer of a complex nitride or complex carbonitride is analyzed in an arbitrary section perpendicular to the surface of the tool body, a periodic concentration variation of Ti and Al is present in the crystal grains having a NaCl type face-centered cubic structure, and when a direction in which a period of a concentration variation in the periodic concentration variation of Ti and Al is minimized is obtained, an angle between the direction in which the period of the concentration variation is minimized and the surface of the tool body is 30 degrees or less, are present.

2. The surface-coated cutting tool according to claim 1, wherein
in a case where a composition of the layer of a complex nitride or complex carbonitride is expressed by a composition formula: (Ti₁₋ₓAlₓ) (C_{y}N_{i-y}), an average amount X_{avg} of Al in a total amount of Ti and Al and an average amount Y_{avg} of C in a total amount of C and N (here, each of X_{avg} and Y_{avg} is in atomic ratio) respectively satisfy 0.40 ≤ X_{avg} ≤ 0.95 and 0 ≤ Y_{avg} ≤ 0.005.

3. The surface-coated cutting tool according to claim 1 or 2, wherein
a ratio of the crystal grains having a NaCl type face-centered cubic structure in which, when the layer of a complex nitride or complex carbonitride is observed in the section, the periodic concentration variation of Ti and Al is present, and the angle between the direction in which the period of the concentration variation in the periodic concentration variation of Ti and Al is minimized and the surface of the tool body is 30 degrees or less, to an area of the layer of a complex nitride or complex carbonitride is 40% by area or more.

4. The surface-coated cutting tool according to any one of claims 1 to 3, wherein
in the crystal grains having a NaCl type face-centered cubic structure in which the periodic concentration variation of Ti and Al is present in the layer of a complex nitride or complex carbonitride and the angle between the direction in which the period of the concentration variation in the periodic concentration variation of Ti and Al is minimized and the surface of the tool body is 30 degrees or less, the period of the periodic concentration variation of Ti and Al is 1 to 10 nm, and a difference between an average of local maximums and an average of local minimums of a periodically varying amount x of Al is 0.01 to 0.1.

5. The surface-coated cutting tool according to any one of claims 1 to 4, wherein
regarding the layer of a complex nitride or complex carbonitride, in a case where the layer is observed in a sectional direction, at grain boundaries between the individual crystal grains having a NaCl type face-centered cubic structure in the layer of a complex nitride or complex carbonitride, fine crystal grains having a hexagonal structure are present, an area ratio of the fine crystal grains present is 5% by area or less, and an average grain size R of the fine crystal grains is 0.01 to 0.3 µm.

6. The surface-coated cutting tool according to any one of claims 1 to 5, wherein
between the tool body and the layer of a complex nitride or complex carbonitride of Ti and Al, a lower layer which is formed of a Ti compound layer including one layer or two or more layers of a Ti carbide layer, a Ti nitride layer, a Ti carbonitride layer, a Ti oxycarbide layer, and a Ti oxycarbonitride layer and has an average total layer thickness of 0.1 to 20 µm is present.

7. The surface-coated cutting tool according to any one of claims 1 to 6, wherein
an upper layer which includes at least an aluminum oxide layer and has an average total layer thickness of 1 to 25 µm is formed in an upper portion of the layer of a complex nitride or complex carbonitride.
